(19) Europäisches Patentamt
European Patent Office
Office européen des brevets

(11) **EP 3 118 639 B1**

(12) **EUROPÄISCHE PATENTSCHRIFT**

(45) Veröffentlichungstag und Bekanntmachung des Hinweises auf die Patenterteilung:
**15.11.2023 Patentblatt 2023/46**

(21) Anmeldenummer: **15176640.9**

(22) Anmeldetag: **14.07.2015**

(51) Internationale Patentklassifikation (IPC):
**G01R 31/36** (2020.01)   **H02J 7/00** (2006.01)
**H01M 10/42** (2006.01)

(52) Gemeinsame Patentklassifikation (CPC):
**H01M 10/482; B60L 58/10; B60L 58/22;**
**G01R 31/367; G01R 31/396; H02J 7/0014;**
**H02J 7/0048; H02J 7/005;** H01M 10/4285;
H01M 10/44; H01M 2220/20; Y02E 60/10;
Y02T 10/70

(54) **VERFAHREN UND VORRICHTUNG ZUM ÜBERWACHEN EINES ZUSTANDES WENIGSTENS EINER VORBESTIMMTEN BATTERIEZELLE EINER BATTERIE**

METHOD AND DEVICE FOR MONITORING A STATE OF AT LEAST ONE PREDETERMINED BATTERY CELL OF A BATTERY

PROCEDE ET DISPOSITIF DE SURVEILLANCE D'UN ETAT D'AU MOINS UN ACCUMULATEUR PREDEFINI D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**18.01.2017 Patentblatt 2017/03**

(73) Patentinhaber:
• **Robert Bosch GmbH**
**70442 Stuttgart (DE)**
• **GS Yuasa International Ltd.**
**Kisshoin, Minami-ku,**
**Kyoto-shi, Kyoto 601-8520 (JP)**

(72) Erfinder:
• **FRIEDRICH, Marco**
**71638 Ludwigsburg (DE)**
• **SPRINGER, Bernhard**
**78588 Denkingen (DE)**

(74) Vertreter: **Isarpatent**
**Patent- und Rechtsanwälte Barth**
**Charles Hassa Peckmann & Partner mbB**
**Postfach 44 01 51**
**80750 München (DE)**

(56) Entgegenhaltungen:
WO-A1-2015/001703    DE-A1-102013 217 752
US-A1- 2014 077 764

**EP 3 118 639 B1**

**Beschreibung**

Die vorliegende Erfindung betrifft ein Verfahren und eine entsprechende Vorrichtung zum Überwachen eines Zustandes wenigstens einer Batteriezelle einer Batterie mit mehreren in Reihe geschalteten oder in Reihe schaltbaren Batteriezellen.

In Batteriezellen können Fehler auftreten. Diese Fehler können zum Beispiel lokale Kurzschlüsse sein, welche beispielsweise durch Dendriten und/oder Verunreinigungen in den Batteriezellen, Alterung der Batteriezellen, Produktionsfehler oder mechanische Einwirkungen verursacht werden. Solche Kurzschlüsse können zur Entstehung von Selbstentladeströmen in den Batteriezellen führen. Diese Fehler stellen in einem geladenen Zustand einer Batterie mit solchen Batteriezellen folglich ein Sicherheitsrisiko dar, da es zu einer lokalen Erhitzung der Batteriezellen kommen kann.

Heutige Batteriesysteme, die typischerweise für Elektromobilitätsanwendungen eingesetzt werden, umfassen Batterien mit mehreren in Reihe geschalteten oder schaltbaren Batteriezellen, durch welche bei einem Laden und/oder Entladen der Batterie ein und derselbe Strom fließt. Die entnehmbare elektrische Energie und Leistung eins solchen Batteriesystems wird durch diejenige Batteriezelle bestimmt, welche eine minimale Kapazität und einen maximalen Innenwiderstand aller Batteriezellen aufweist. Deshalb ist es vorteilhaft, dass in einem solchen Batteriesystem Batteriezellen eingebaut werden, die möglichst ähnliche Kapazitäten und Innenwiderstände aufweisen. Es ist bekannt, dass durch Alterung einer Batteriezelle sich deren Kapazität typischerweise verringert und sich deren Innenwiderstand typischerweise erhöht. Durch Alterung und in den Batteriezellen eines zuvor genannten Batteriesystems fließenden Geänderte Beschreibungsseite 2 (Reinversion)

Selbstentladeströme entladen sich die Batteriezellen unterschiedlich schnell. Dies führt auf Dauer zu unterschiedlichen Ladezuständen der Batteriezellen. Deshalb ist es notwendig, einen Ladezustandsausgleich zwischen den Ladezuständen der Batteriezelle eines solchen Batteriesystems regelmäßig durchzuführen. Dieser Vorgang wird üblicherweise als "Balancing" bezeichnet.

Aus dem Dokument CN 102231546 B ist eine Batterie mit mehreren Batteriezellen bekannt. Dabei wird ein Zustand der Batterie von einem Batteriemanagement-System überwacht. Das Batteriemanagement-System ist dazu ausgebildet, ein Durchführen eines Ladezustandsausgleichs zwischen unterschiedlichen Ladezuständen der Batteriezellen der Batterie einzuleiten und anzusteuern.

Dokument US 2014/0077764 A1 beschreibt ein Verfahren zur Steuerung einer Batterie mit mehreren Batteriezellen, wobei der Vorgang des gesteuerten Ladezustandsausgleich zwischen den Batteriezellen zur Bestimmung eines Alterungszustandes dient, indem die während des Ladezustandsausgleichs fließenden Ladungen gemessen oder geschätzt werden und mit bekannten Größen der Batteriezellen vor Verwendung in der Batterie in Beziehung gesetzt werden.

Aus dem Dokument US 2013/0018606 ist eine Batterie mit mehreren Batteriezellen bekannt. Dabei werden mehrere Ladezustandsausgleiche zwischen unterschiedlichen Ladezuständen der Batteriezellen der Batterie durchgeführt. Ferner wird für jede Batteriezelle eine Häufigkeit bestimmt, mit der eine in der jeweiligen Batteriezelle gespeicherte Energie während der mehreren Ladezustandsausgleiche verändert wird. Anhand einer Auswertung der für jede Batteriezelle bestimmten Häufigkeit wird festgestellt, ob sich die jeweilige Batteriezelle in einem fehlerhaften Zustand befindet. Ein solcher fehlerhafter Zustand kann infolge eines internen Kurzschlusses der jeweiligen Batteriezelle auftreten.

Offenbarung der Erfindung

Erfindungsgemäß werden ein Verfahren und eine Vorrichtung zum Überwachen eines Zustandes wenigstens einer vorbestimmten Batteriezelle einer Batterie mit mehreren in Reihe geschalteten oder in Reihe schaltbaren Batteriezellen bereitgestellt, wie im beigefügten Anspruchssatz definiert. Bevor im Folgenden eine detaillierte Beschreibung der Ausführungsformen der vorliegenden Erfindung unter Bezugnahme auf die beigefügten Zeichnungen erfolgt, werden einige Aspekte der Erfindung, die zum Verständnis der Erfindung beitragen, gesondert aufgeführt. Es sollte jedoch beachtet werden, dass die Erfindung durch die beigefügten Ansprüche definiert ist, und alle Beispiele und Ausführungsformen, die nicht durch diese Ansprüche abgedeckt sind, sind auch als Aspekte zu verstehen, die zum Verständnis der Erfindung beitragen.

Das erfindungsgemäße Verfahren umfasst die Verfahrensschritte gemäß Anspruch 1.

Bei dem erfindungsgemäßen Verfahren umfasst die Auswertung der erfassten Spannung eine Auswertung der zumindest nach dem Beenden des während der zweiten Phase vorkommenden Entladens erfassten Spannung und eine Auswertung der zumindest nach dem Beenden des während der dritten Phase vorkommenden Ladens erfassten Spannung.

Bei dem erfindungsgemäßen Verfahren ist zu berücksichtigen, dass der Ladezustand einer Batteriezelle Werte aufweisen kann, die zwischen 0% und 100% oder zwischen 0 und 1 liegen können. Dabei wird unter einer Batteriezelle mit einem Ladezustand, der einen Wert von 0% oder 0 aufweist, eine Batteriezelle verstanden, die vollständig entladen ist. Ferner wird unter einer Batteriezelle mit einem Ladezustand, der einen Wert von 100% oder 1 aufweist, eine Batteriezelle verstanden, die vollständig geladen ist.

Bei dem erfindungsgemäßen Verfahren kann der vordefinierte Ladezustand beispielsweise einen Wert von 50% oder von 80% oder von 100% aufweisen.

Bei einem zuvor beschriebenen Verfahren umfasst die wenigstens eine vorbestimmte Batteriezelle bevorzugt alle Batteriezellen der Batterie.

Bei einem zuvor beschriebenen Verfahren können nach einem Beenden der ersten Phase und vor einem Beginn der zweiten Phase mehrere Entlade- und Ladevorgänge nacheinander auftreten. Dabei kann während wenigstens eines Ladevorgangs jeweils ein Laden der Batterie erfolgen, durch das die wenigstens eine Batteriezelle der Batterie wie während der dritten Phase auf den vordefinierten Ladezustand gebracht wird. Bei einem zuvor beschriebenen Verfahren können folglich die zweite Phase und die dritte Phase nach dem Beenden der ersten Phase mehrfach wiederholt nacheinander auftreten. Ferner kann zwischen wenigstens einem Entladevorgang und einem nach diesem folgenden Ladevorgang eine vordefinierte Pausenphase vorgesehen sein. Auch kann bei einem Entladevorgang beziehungsweise bei einem während einer zweiten Phase vorkommenden Laden ein teilweises Entladen der Batterie erfolgen. Weiterhin kann bei einem Ladevorgang beziehungsweise bei einem während einer dritten Phase vorkommenden Laden ein teilweises Laden der Batterie erfolgen. Wenn die Batterie in einem Fahrzeug eingesetzt wird, können ein solches teilweise Entladen und ein solches teilweise Laden der Batterie während einer Fahrzeugnutzung vorgenommen werden. Für die Anwendbarkeit eines zuvor beschriebenen Verfahrens sind ein solches teilweises Entladen und ein solches teilweises Laden der Batterie unschädlich. Hier zu berücksichtigen ist, dass ein Bestimmen der Informationen zum Erkennen des Zustands der wenigstens einen vorbestimmten Batteriezelle beziehungsweise ein Erkennen des Zustands der wenigstens einen vorbestimmten Batteriezelle stets unmittelbar nach einem Beenden eines Ladens durchführbar ist, bei dem die wenigstens eine Batteriezelle der Batterie auf den vordefinierten Ladezustand gebracht wird.

Erfindungsgemäß wird ein erster Analyseschritt zum Erkennen des Zustandes der wenigstens einen vorbestimmten Batteriezelle und ein zweiter Analyseschritt zum Erkennen des Zustands der wenigstens einen vorbestimmten Batteriezelle durchgeführt. Dabei umfasst der erste Analyseschritt das Erfassen der von der wenigstens einen vorbestimmten Batteriezelle bereitgestellten Spannung zumindest nach einem Beenden des während der zweiten Phase vorkommenden Entladens und die Auswertung der zumindest nach dem Beenden des während der zweiten Phase vorkommenden Entladens erfassten Spannung. Weiter umfasst der zweite Analyseschritt das Erfassen der von der wenigstens einen vorbestimmten Batteriezelle bereitgestellten Spannung zumindest nach einem Beenden des in der dritten Phase vorkommenden Ladens und die Auswertung der zumindest nach Beenden des während der dritten Phase vorkommenden Ladens erfassten Spannung. Bevorzugt werden der erste Analyseschritt nach einem Beenden der zweiten Phase und/oder der zweite Analyseschritt nach einem Beenden der dritten Phase durchgeführt.

Bei dem erfindungsgemäßen Verfahren stimmt ein Zeitpunkt, zu dem das während der zweiten Phase durchgeführte Entladen beendet wird, mit einem weiteren Zeitpunkt überein, zu dem eine einzelne oder eine Anzahl der Batteriezellen der Batterie insbesondere gleichzeitig einen weiteren vordefinierten Ladezustand erreicht haben. Zu diesem weiteren Zeitpunkt weisen sonstige Batteriezellen der Batterie jeweils einen gegenüber dem weiteren vordefinierten Ladezustand größeren Ladezustand auf. Der weitere vordefinierte Ladezustand kann beispielsweise einen Wert von beispielsweise 10% aufweisen. Bei dem erfindungsgemäßen Verfahren stimmt der Zeitpunkt, zu dem das während der dritten Phase durchgeführte Laden beendet wird, mit einem Zeitpunkt überein, zu dem eine einzelne oder eine Anzahl der Batteriezellen der Batterie insbesondere gleichzeitig den vordefinierten Ladezustand erreicht haben. Zu diesem Zeitpunkt weisen sonstige Batteriezellen der Batterie jeweils einen gegenüber dem vordefinierten Ladezustand kleineren Ladezustand auf.

Bei einem zuvor beschriebenen Verfahren wird bevorzugt ein sechster Schritt durchgeführt. Der sechste Schritt umfasst ein Erkennen einer jeden zu prüfende Batteriezelle der wenigstens einen vorbestimmten Batteriezelle, die unmittelbar nach dem Beenden des während der dritten Phase durchgeführten Ladens einen gegenüber dem vordefinierten Ladezustand kleineren Ladezustand aufweist. Dabei erfolgt das Erkennen jeder zu prüfenden Batteriezelle der wenigstens einen vorbestimmten Batteriezelle anhand der Auswertung der nach dem Beenden des während der dritten Phase vorkommenden Ladens erfassten Spannung.

Bei einem zuvor beschriebenen Verfahren werden alle Batteriezellen der Batterie während der ersten Phase zunächst auf den vordefinierten Ladezustand gebracht. Nachdem das während der zweiten Phase durchgeführte Entladen beendet wird, stellen die Batteriezellen der Batterie unterschiedliche Spannungen bereit und weisen folglich auch unterschiedliche Ladezustände auf. Dabei stellen sowohl mäßig funktionierende Batteriezellen der Batterie als auch potentiell gefährliche Batteriezellen der Batterie, kleinere Spannungen als gut funktionierende Batteriezellen der Batterie bereit. Als mäßig funktionierende Batteriezellen werden Batteriezellen bezeichnet, die produktionsbedingt oder alterungsbedingt zwar geringe Kapazitäten aber keine oder sehr geringe Selbstentladeströme aufweisen. Als potentiell gefährliche Batteriezellen werden Batteriezellen bezeichnet, die hohe Selbstentladeströme aufweisen. Als gut funktionierende Batteriezellen werden Batteriezellen bezeichnet, die hohe Kapazitäten und keine oder sehr geringe Selbstentladeströme aufweisen. Nachdem das während der zweiten Phase durchgeführte Entladen beendet wird, weisen folglich sowohl die mäßig funktionierenden Batteriezellen als auch die potentiell gefährlichen Batteriezellen der Batterie kleinere Ladezustände als die gut funktionierenden Batteriezellen der Batterie auf. Dies kann bevorzugt durch den nach dem Beenden der zweiten Phase durchgeführten ersten Analyseschritt erkannt werden. Jedoch ist nach dem Beenden der zweiten Phase noch keine Unterscheidung zwischen den mäßig funktionierenden Batteriezellen und den potentiell gefährlichen Batteriezellen möglich. Wenn bei einem zuvor beschriebenen Verfahren die zweite Phase und die dritte Phase mehrfach wiederholt nacheinander auftreten, kann der erste Analyseschritt bevorzugt nach einem Beenden einer jeden zweiten Phase durchgeführt werden. Mit anderen Worten wird der erste Analyseschritt bevorzugt vor einem Beginn einer jeden dritten Phase durchgeführt.

Nachdem das während der dritten Phase durchgeführte Entladen beendet wird, weisen sowohl die gut funktionierenden Batteriezellen als auch die mäßig funktionierenden Batteriezellen den vordefinierten Ladezustand und die potentiell gefährlichen Batteriezellen jeweils einen gegenüber dem vordefinierten Ladezustand kleineren Ladezustand auf. Der Grund dafür ist, dass allen Batteriezellen der Batterie jeweils eine und dieselbe erste Ladungsmenge durch das während der zweiten Phase durchgeführte Entladen entnommen wird. Dabei muss den Batteriezellen der Batterie, die keine oder sehr geringe Selbstentladeströme aufweisen, eine Ladungsmenge, die in etwa gleich mit der ersten Ladungsmenge ist, zugeführt werden, damit diese jeweils den vordefinierten Ladezustand aufweisen. Diese Tatsache kann bei einem zuvor beschriebenen Verfahren durch eine Wahl des Zeitpunktes, zu dem das während der dritten Phase durchgeführte Laden beendet wird, ausgenutzt werden. So wird dieser Zeitpunkt bevorzugt derartig ausgewählt, dass allen Batteriezellen der Batterie, durch das während der dritten Phase durchgeführte Laden eine Ladungsmenge zugeführt wird, die in etwa gleich mit der ersten Ladungsmenge ist. Das bedeutet, dass nachdem das während der dritten Phase durchgeführte Laden beendet ist, die potentiell gefährlichen Batteriezellen den vordefinierten Ladezustand jeweils nicht aufweisen können. Der Grund dafür ist, dass den potentiell gefährlichen Batteriezellen eine Ladungsmenge während der dritten Phase zugeführt werden müsste, die deutlich höher als die erste Ladungsmenge ist, damit diese jeweils den vordefinierten Ladezustand aufweisen. Dadurch könnten Ladungsverluste kompensiert werden, die infolge der hohen Selbstentladeströme der potentiell gefährlichen Batteriezellen entstehen würden. Das heißt, dass zu dem zuvor genannten Zeitpunkt nur die potentiell gefährlichen Batteriezellen jeweils einen gegenüber dem vordefinierten Ladezustand kleineren Ladezustand aufweisen. Anders ausgedrückt, kann bei einem zuvor beschriebenen Verfahren eine jede potentiell gefährliche Batteriezelle der Batterie bevorzugt durch den zweiten Analyseschritt identifiziert und als eine zu prüfende Batteriezelle klassifiziert werden.

Bei einem zuvor beschriebenen Verfahren wird bevorzugt ein siebenter Schritt durchgeführt. Der siebente Schritt umfasst ein Erkennen einer jeden weiteren zu prüfenden Batteriezelle der wenigstens einen vorbestimmten Batteriezelle, die unmittelbar nach dem Beenden des während der zweiten Phase durchgeführten Entladens einen Ladezustand aufweist, der einen Ladezustandsschwellenwert unterschreitet, und keine zu prüfende Batteriezelle ist. Dabei erfolgt das Erkennen jeder weiteren zu prüfenden Batteriezelle der wenigstens einen vorbestimmten Batteriezelle anhand der Auswertung der erfassten Spannung. Mit anderen Worten kann jede Batteriezelle der wenigstens einen vorbestimmten Batteriezelle, die unmittelbar nach dem Beenden des während der zweiten Phase durchgeführten Entladen einen Ladezustand aufweist, der einen Ladezustandsschwellenwert unterschreitet, und insbesondere durch den zweiten Analyseschritt nicht als eine potentiell gefährliche Batteriezelle klassifiziert wurde, bevorzugt als eine mäßig funktionierende Batteriezelle erkannt werden. Jede so erkannte mäßig funktionierende Batteriezelle kann eine Batteriezelle sein, deren Kapazität infolge einer überdurchschnittlich hohen Alterung gering ist.

Nachdem das während der zweiten Phase durchgeführte Entladen beendet wird, weisen die gut funktionierenden Batteriezellen der Batterie größere Ladezustände als die mäßig funktionierenden und als die potentiell gefährlichen Batteriezellen der Batterie auf. Diese Tatsache kann bei einem zuvor beschriebenen Verfahren, das den siebten Schritt umfasst, bevorzugt durch eine geeignete Wahl des Ladezustandsschwellenwerts ausgenutzt werden. Da alle potentiell gefährlichen Batteriezellen der Batterie gemäß dem sechsten Schritt erkennbar sind, so können gemäß dem siebten Schritt sehr frühzeitig auch alle mäßig funktionierenden Batteriezellen der Batterie erkannt werden. Anders ausgedrückt, kann bei einem zuvor beschriebenen Verfahren, das den siebten Schritt umfasst, eine jede mäßig funktionierende Batteriezelle der Batterie bevorzugt durch den ersten Analyseschritt und den zweiten Analysenschritt identifiziert und als eine weitere zu prüfende Batteriezelle klassifiziert werden.

Vorteilhaft bei einem zuvor beschriebenen Verfahren ist, dass jede potentiell gefährliche Batteriezelle und/oder jede mäßig funktionierende Batteriezelle der Batterie sehr schnell erkannt werden kann. Dadurch können diesbezügliche Sicherheitsmaßnahmen sehr frühzeitig eingeleitet werden.

Vorteilhaft bei einem zuvor beschriebenen Verfahren ist ferner, dass zur Erkennung jeder potentiell gefährlichen Batteriezelle und/oder jeder mäßig funktionierenden Batteriezelle keine weiteren technischen Mittel, wie zum Beispiel Hardware, zusätzlich zu Messvorrichtungen erforderlich sind, die üblicherweise in heutigen Batteriesystemen mit einer wie zuvor beschriebenen Batterie schon vorhanden sind. Die zuvor genannte Erkennung erfordert lediglich eine zusätzliche Softwarefunktion.

Bei einem zuvor beschriebenen Verfahren werden bevorzugt ein achter und ein neunter Schritt durchgeführt. Der achte Schritt umfasst ein Erfassen des durch die Batterie fließenden Stromes zumindest während des Entladens, das während der zweiten Phase vorkommt, und zumindest während des Ladens, das während der dritten Phase vorkommt. Der neunte Schritt umfasst ein Bestimmen einer Kapazität und/oder eines Selbstentladestroms der wenigstens einen vorbestimmten Batteriezelle anhand einer Auswertung der erfassten Spannung und des erfassten Stroms.

Bei einem zuvor beschriebenen Verfahren wird bevorzugt ein zehnter Schritt durchgeführt. Der zehnte Schritt umfasst ein Durchführen wenigstens eines Ladezustandsausgleichs zwischen Ladezuständen der Batteriezellen nach einem Beenden der dritten Phase.

Es kann vorgesehen sein, dass der wenigstens eine Ladezustandsausgleich jeweils ein passiver Ladezustandsausgleich ist. Bei jedem passiven Ladezustandsausgleich wird eine jede Batteriezelle der Batterie, die jeweils einen Ladezustand aufweist, der größer als ein minimaler Ladezustand der Batteriezellen der Batterie ist, jeweils durch ein gesteuertes Entladen auf den minimalen Ladezustand gebracht. Dabei erfolgt jedes gesteuerte Entladen jeweils über einen bevorzugt eine geringe Widerstandstoleranz aufweisenden Widerstand, welcher der jeweiligen Batteriezelle zugeordneten ist. Dabei wird ferner jeder zu entladenen Batteriezelle die jeweilige elektrische Energiemenge über den dieser zugeordneten Widerstand entnommen und in Wärme umgewandelt.

Bei einem zuvor beschriebenen Verfahren werden bevorzugt ein elfter und ein zwölfter und/oder ein dreizehnter Schritt durchgeführt. Der elfte Schritt umfasst ein Erfassen von weiteren Informationen über ein Verhalten der wenigstens einen vorbestimmten Batteriezelle der Batterie beim Durchführen des wenigstens einen Ladezustandsausgleichs.

Es kann vorgesehen sein, dass die erfassten weiteren Informationen über die wenigstens eine vorbestimmte Batteriezelle erste Informationen aufweisen, die eine jede Häufigkeit umfassen, mit der eine in einer vorbestimmten Batteriezelle gespeicherten Energie während des wenigstens einen Ladezustandsausgleichs verändert wird.

Es kann vorgesehen sein, dass die erfassten weiteren Informationen über die wenigstens eine vorbestimmten Batteriezelle zweite Informationen aufweisen, die eine jede Spannung umfassen, die von einer vorbestimmten Batteriezelle während des wenigstens einen Ladezustandsausgleichs bereitgestellt wird.

Ferner kann es vorgesehen sein, dass die erfassten Informationen über die wenigstens eine vorbestimmte Batteriezelle dritte Informationen umfassen, die eine jede Energie- oder Ladungsmenge umfassen, die einer vorbestimmten Batteriezelle während des wenigstens einen Ladezustandsausgleichs zugeführt oder entnommen wird.

In einem Fall, in dem der wenigstens eine Ladezustandsausgleich jeweils ein passiver Ladezustandsausgleich ist, umfassen die dritten Informationen jede Energie- oder Ladungsmenge, die einer vorbestimmten Batteriezelle während des wenigstens einen Ladezustandsausgleichs entnommen wird. Dabei wird jede entnommene Energie- oder Ladungsmenge bevorzugt anhand einer über einen entsprechenden Zeitraum durchgeführten Integration eines Stromes bestimmt, der während des wenigstens einen Ladezustandsausgleichs durch den Widerstand fließt, welcher der jeweiligen vorbestimmten Batteriezelle zugeordnet ist. In diesem Fall umfassen die dritten Informationen bevorzugt auch jeden Strom, der während des wenigstens einen Ladezustandsausgleichs durch einen Widerstand fließt, der einer vorbestimmten Batteriezelle zugeordnet ist.

Der zwölfte Schritt umfasst ein Erkennen jeder auch als eine potentiell gefährliche Batteriezelle bezeichneten zu prüfenden Batteriezelle und/oder jeder auch als eine mäßig funktionierende Batteriezelle bezeichneten weiteren zu prüfenden Batteriezelle anhand einer Auswertung der erfassten weiteren Informationen über die wenigstens eine vorbestimmte Batteriezelle, insbesondere anhand einer Auswertung der ersten Informationen. Beispielsweise wird in dem Fall, in dem der wenigstens eine Ladezustandsausgleich jeweils ein passiver Ladezustandsausgleich ist, eine jede vorbestimmte Batteriezelle, deren Ladezustand sehr selten in Vergleich zu anderen vorbestimmten Batteriezellen reduziert wird, bevorzugt als eine potentiell gefährliche Batteriezelle erkannt und als eine zu prüfende Batteriezelle klassifiziert.

Der dreizehnte Schritt umfasst ein Bestimmen der Kapazität und/oder des Selbstentladestroms der wenigstens einen vorbestimmten Batteriezelle anhand der erfassten weiteren Informationen über die wenigstens eine vorbestimmte Batteriezelle, insbesondere anhand der zweiten und/oder der dritten Informationen.

Bei einem zuvor beschriebenen Verfahren, welches den elften Schritt umfasst, erfolgt das Bestimmen der Kapazität und/oder des Selbstentladestroms der wenigstens einen vorbestimmten Batteriezelle bevorzugt anhand einer Auswertung der von dieser bereitgestellten und erfassten Spannung, des erfassten Stromes und der erfassten weiteren Informationen über die wenigstens eine vorbestimmte Batteriezelle.

Bei einem zuvor beschriebenen Verfahren werden ein vierzehnter und/oder ein fünfzehnter Schritt durchgeführt. Der vierzehnte Schritt umfasst ein Erkennen jeder Batteriezelle, deren Selbstentladestrom bestimmt wird, jeweils als Batteriezelle, die sich in einem kritischen Zustand befindet, wenn der Selbstentladestrom dieser Batteriezelle einen Stromschwellenwert überschreitet. Eine sich in einem kritischen Zustand befindliche Batteriezelle wird im Folgenden auch als gefährliche Batteriezelle bezeichnet. Der fünfzehnte Schritt umfasst ein Erkennen jeder Batteriezelle, deren Kapazität bestimmt wird, jeweils als eine Batteriezelle, die sich in einem unerwünschten Zustand befindet, wenn die Kapazität dieser Batteriezelle jeweils einen Kapazitätsschwellenwert unterschreitet. Eine sich in einem unerwünschten Zustand befindliche Batteriezelle wird im Folgenden auch als überdurchschnittlich stark gealterte Batteriezelle bezeichnet. Auf diese Weise, kann jede gefährliche Batteriezelle und/oder jede überdurchschnittlich stark gealterte Batteriezelle der Batterie erkannt werden. Dabei kann die Batterie ein Teil eines heute in Serie produzierten Batteriesystems mit einer festen Verschaltung von Batteriezellen der Batterie sein, bei dem ein Weiterbetrieb der wie zuvor beschrieben erkannten Batteriezellen durch ein Abschalten der Batterie verhindert werden kann. Ferner kann die Batterie ein Teil eines neuartigen Batteriesystems sein, bei dem ein Zuschalten und/oder ein Überbrücken einer einzelner Batteriezelle oder eines einzelnen Batteriezellmoduls der Batterie mit Hilfe einer Elektronikschaltung möglich ist. Ein Weiterbetrieb eines solchen neuartigen Batteriesystems kann mit einer verringerten Anzahl von gut funktionieren Batteriezellen der Batterie erfolgen, aber ohne eine Beteiligung von gefährlichen Batteriezellen der Batterie und/oder auch ohne eine Beschränkung durch überdurchschnittlich stark gealterte Batteriezellen der Batterie. Eine Fehlerbehandlung jeder gefährlichen Batteriezelle und/oder jeder überdurchschnittlich stark gealterten Batteriezelle kann beispielsweise durch ein Austausch der jeweiligen Batteriezelle oder eines die jeweiligen Batteriezelle aufweisenden Batteriezellmoduls und/oder durch ein Überführen der jeweiligen Batteriezelle oder des jeweiligen Batteriemoduls in einen sicheren Zustand erfolgen. Dabei kann das Überführen in den sicheren Zustand durch ein Entladen und/oder durch ein Unterbinden eines erneuten Ladens der jeweiligen Batteriezelle oder des jeweiligen Batteriemoduls erfolgen. Bei einem zuvor beschriebenen Verfahren wird bevorzugt jede Batteriezelle, deren Selbstentladestrom bestimmt wird, zuerst jeweils als eine zu prüfende Batteriezelle erkannt. Bei einem zuvor beschriebenen Verfahren wird bevorzugt jede Batteriezelle, deren Kapazität bestimmt wird, zuerst jeweils als eine weitere zu prüfende Batteriezelle erkannt. Auf diese Weise wird eine Bestimmung des Selbstentladestroms und/oder der Kapazität nur für eine verringerte Anzahl von Batteriezellen durchgeführt, so dass jede gefährliche Batteriezelle und/oder jede überdurchschnittlich stark gealterte Batteriezelle sehr schnell erkannt werden kann.

Ein weiterer Aspekt der Erfindung betrifft eine Vorrichtung zum Überwachen eines Zustands wenigstens einer vorbestimmten Batteriezelle einer Batteriezellgruppe, die aus wenigstens einer Batteriezelle einer Batterie besteht, die mehrere in Reihe geschaltete oder in Reihe schaltbare Batteriezellen aufweist. Dabei ist die Vorrichtung dazu ausgebildet, ein Vorliegen einer ersten Phase, während der ein Versetzen der Batterie in einen ersten Zustand erfolgt, in dem die Batteriezellen der Batterie jeweils einen vordefinierten Ladezustand aufweisen, zu erkennen. Ferner ist die Vorrichtung dazu ausgebildet, ein Vorliegen einer nach der ersten Phase folgenden zweiten Phase zu erkennen, während der ein Entladen der sich in dem ersten Zustand befindlichen Batterie erfolgt. Auch ist die Vorrichtung dazu ausgebildet, ein Vorliegen einer nach der zweiten Phase folgenden dritten Phase zu erkennen, während der ein Laden der Batterie bis zu einem Zeitpunkt erfolgt, zu dem wenigstens eine Batteriezelle der Batterie den vordefinieren Ladezustand aufweist. Weiterhin ist die Vorrichtung dazu ausgebildet, Informationen über den Zustand der wenigstens einen vorbestimmten Batteriezelle der Batteriezellgruppe gemäß dem zuvor beschriebenen erfindungsgemäßen Verfahren zu bestimmen.

Die Vorrichtung ist ferner bevorzugt dazu ausgebildet, ein Durchführen wenigstens eines Ladezustandsausgleichs zwischen Ladezuständen der Batteriezellen zu erkennen.

Eine zuvor beschriebene Vorrichtung ist bevorzugt dazu ausgebildet, ein zuvor beschriebenes Verfahren durchzuführen.

Es kann vorgesehen sein, dass die Batteriezellgruppe alle Batteriezellen der Batterie umfasst. Hier kann eine zuvor beschriebene Vorrichtung bevorzugt ein zentrales Steuergerät für die zuvor beschriebene Batterie sein. Alternativ dazu kann es vorgesehen sein, dass die Batterie mehrere Batteriemodule umfasst, die jeweils wenigstens eine Batteriezelle der Batterie aufweisen, und, dass die Batteriezellgruppe aus der wenigstens einen Batteriezelle eines Batteriezellmoduls der Batterie besteht. Hier kann eine beschriebene Vorrichtung bevorzugt ein zentrales Steuergerät für das Batteriezellmodul mit der wenigstens einen Batteriezelle der Batteriezellgruppe sein.

Kurze Beschreibung der Zeichnung

Nachfolgend wird ein Ausführungsbeispiel der Erfindung unter Bezugnahme auf die begleitende Zeichnung im Detail beschrieben. Für gleiche Komponenten und Parameter werden jeweils gleiche Bezugszeichen verwendet. In der Zeichnung ist:

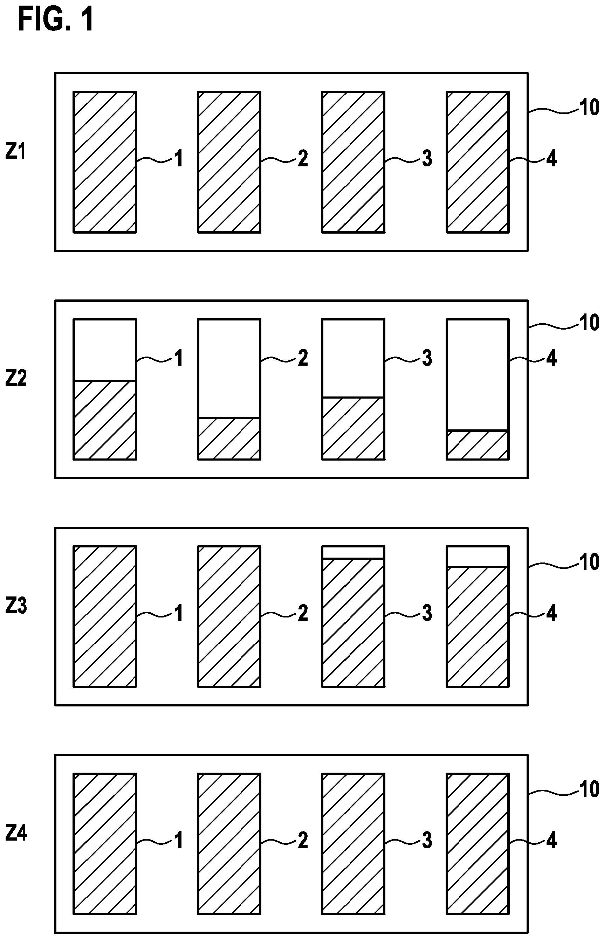

Figur 1    eine schematische Darstellung mehrerer Zustände einer und derselben Batterie eines Fahrzeuges.

Ausführungsform der Erfindung

Figur 1 zeigt einen ersten Zustand Z1, einen zweiten Zustand Z2, einen dritten Zustand Z3 und einen vierten Zustand Z4 einer und derselben Batterie 10 eines Fahrzeuges. Die Batterie 10 umfasst eine erste Batteriezelle 1, eine zweite Batteriezelle 2, eine dritte Batteriezelle 3 und eine vierte Batteriezelle 4. Die vier Batteriezellen 1, 2, 3, 4 sind in Reihe geschaltet.

Im Folgenden wird ein jeder Ladezustand, den eine Batteriezelle $i$ der vier Batteriezellen 1, 2, 3, 4 der sich in einem Zustand $Zj$ der vier Zustände Z1, Z2 Z3, Z4 befindlichen Batterie 10 aufweist, mit $Lji$ bezeichnet. Hier ist zu berücksichtigen, dass ein Ladezustand einer Batteriezelle zwischen 0% und 100% beziehungsweise zwischen 0 und 1 liegen kann, wobei der Ladezustand 0% beziehungsweise 0 beträgt, wenn die jeweilige Batteriezelle vollständig entladen ist, und 100% beziehungsweise 1 beträgt, wenn die jeweilige Batteriezelle vollständig geladen ist. Im Folgenden wird ferner eine jede Ladungsmenge, die in einer Batteriezelle i der vier Batteriezellen 1, 2, 3, 4 der sich in einem Zustand Zj der vier Zustände Z1, Z2, Z3, Z4 befindlichen Batterie 10 gespeichert ist, mit Qji bezeichnet. Dabei ist j eine natürliche Zahl, die für den ersten Zustand Z1 einen Wert von 1, für den zweiten Zustand Z2 einen Wert von 2, für den dritten Zustand Z3 einen Wert von 3 und für den vierten Zustand Z4 einen Wert von 4 aufweist. Ferner ist i eine natürliche Zahl, die für die erste Batteriezelle 1 einen Wert von 1, für die zweite Batteriezelle 2 einen Wert von 2, für die dritte Batteriezelle 3 einen Wert von 3 und für die vierte Batteriezelle 4 einen Wert von 4 aufweist. In der Figur 1 wird für die sich in einem Zustand Zj der vier Zustände Z1, Z2, Z3, Z4 befindliche Batterie 10 eine Größe des Ladezustands Lji einer Batteriezelle i der vier Batteriezellen 1, 2, 3, 4 durch ein Verhältnis zwischen einem straffierten Bereich der jeweiligen Batteriezelle i und einer Gesamtfläche dieser symbolisiert.

Eine gemäß einer ersten Ausführungsform der Erfindung durchzuführende Erkennung einer jeden Batteriezelle 3, 4 der Batterie 10, die einen hohen Selbstentladestrom aufweist, wird in Zusammenhang mit der Figur 1 näher beschrieben. Im Folgenden werden die dritte und die vierte Batteriezelle 3, 4 der Batterie 10, die jeweils einen hohen Selbstentladestrom aufweisen, auch als potentiell gefährliche Batteriezellen 3, 4 bezeichnet.

Gemäß der ersten Ausführungsform wird die Batterie 10 während einer ersten Phase in den ersten Zustand Z1 versetzt, in dem die vier Batteriezellen 1, 2, 3, 4 jeweils einen vordefinierten Ladezustand von beispielsweise 100% aufweisen. Das bedeutet, dass jede Batteriezelle 1, 2, 3, 4 der sich in dem ersten Zustand Z1 befindlichen Batterie 10 einen Ladezustand L11, L12, L13, L14 aufweist, der gleich mit der vordefinierten Ladezustand ist. Dies wird erreicht, indem das Fahrzeug zunächst an ein Ladegerät solange angeschlossen wird, bis wenigstens eine Batteriezelle 1, 2der Batterie 10 den vordefinierten Ladezustand aufweist. Unmittelbar danach wird ein Ladezustandsausgleich zwischen den Ladezuständen der vier Batteriezellen 1, 2, 3, 4 durchgeführt. Anschließend wird die Batterie 10 solange nachgeladen, bis alle vier Batteriezellen 1, 2, 3, 4 den vordefinierten Ladezustand aufweisen. Dies wird erreicht, indem das Fahrzeug erneut an das Ladegerät angeschlossen wird. Der vordefinierte Ladezustand kann auch andere Werte aufweisen, die jeweils größer als 0% und kleiner als 100% sind. Hier wird für den vordefinierten Ladzustand einen Wert von 100% nur beispielhaft ausgewählt.

Im Folgenden wird jede Ladungsmenge Q1i, die in einer Batteriezelle i der vier Batteriezellen 1, 2, 3, 4 der sich in dem ersten Zustand Z1 befindlichen Batterie 10 gespeichert ist, auch als Kapazität Q1i der jeweiligen Batteriezelle i bezeichnet.

Gemäß der ersten Ausführungsform wird während einer unmittelbar nach der ersten Phase folgenden zweiten Phase ein Entladen der Batterie 10 durchgeführt. Dies wird erreicht, indem das Fahrzeug über eine Gesamtdauer der zweiten Phase ab und zu gefahren wird. Beispielsweise erstreckt sich die zweite Phase über zwei Tage. Während der zweiten Phase wird die Batterie 10 nur entladen aber nicht geladen. Dabei befindet sich die Batterie 10 an einem Ende der zweiten Phase in dem zweiten Zustand Z2, in dem wenigstens eine Batteriezelle 4 der Batterie 10 einen weiteren vordefinierten Ladezustand von beispielsweise 10% aufweist. Der weitere vordefinierte Ladezustand kann auch andere Werte aufweisen, die jeweils größer als 0% und kleiner als der vordefinierte Ladezustand sind. Gemäß der ersten Ausführungsform wird eine jede Spannung, die von einer Batteriezelle i der vier Batteriezellen 1, 2, 3, 4 der sich in dem zweiten Zustand Z2 befindlichen Batterie 10 bereitgestellt wird, erfasst. Aus diesen erfassten Spannungen werden die Ladezustände L21, L22, L23, L24 der vier Batteriezellen 1, 2, 3, 4 der sich in dem zweiten Zustand Z2 befindlichen Batterie 10 jeweils bestimmt und untereinander verglichen. Ferner wird ein Entladestrom I2(t), der durch die Batterie 10 während der zweiten Phase fließt, in Abhängigkeit von der Zeit t erfasst. Im Folgenden wird die zweite Batteriezelle 2 der Batterie 10, die produktions- oder alterungsbedingt jeweils eine geringe Kapazität Q12 aber kein oder nur einen sehr geringen Selbstentladestrom aufweist, auch als mäßig funktionierende Batteriezelle 2 bezeichnet. Im Folgenden wird ferner die erste Batteriezelle 1 der Batterie 10, die jeweils eine hohe Kapazität Q11 und kein oder einen sehr geringen Selbstentladestrom aufweist, auch als gut funktionierende Batteriezelle 1 bezeichnet. Am Ende der zweiten Phase werden sowohl die mäßig funktionierende Batteriezelle 2 der Batterie 10 als auch die potentiell gefährlichen Batteriezellen 3, 4 der Batterie 10 stärker als die gut funktionierende Batteriezelle 1 der Batterie 10 entladen sein. Aus der Figur 1 ist ersichtlich, dass die zweite Batteriezelle 2, die dritte Batteriezelle 3 und die vierte Batteriezelle 4 jeweils stärker als die erste Batteriezelle 1 entladen sind. Somit kann am Ende der zweiten Phase nur festgestellt werden, dass die erste Batteriezelle 1 einen besseren Gesundheitszustand als jede andere Batteriezelle 2, 3, 4 der Batterie 10 aufweist.

Gemäß der ersten Ausführungsform wird während einer unmittelbar nach der zweiten Phase folgenden dritten Phase ein Laden der Batterie 10 bis zu einem frühesten Zeitpunkt durchgeführt, zu dem eine oder mehrere der Batteriezellen 1, 2, 3, 4 der Batterie 10 gleichzeitig den vordefinierten Ladezustand erreicht haben. An einem Ende der dritten Phase befindet sich die Batterie 10 in dem dritten Zustand Z3. Gemäß der ersten Ausführungsform wird eine jede Spannung, die von einer Batteriezelle i der vier Batteriezellen 1, 2, 3, 4 der sich in dem dritten Zustand Z3 befindlichen Batterie 10 bereitgestellt wird, erfasst. Aus diesen erfassten Spannungen werden die Ladezustände L31, L32, L33, L34 der vier Batteriezellen 1, 2, 3, 4 der sich in dem dritten Zustand Z3 befindlichen Batterie 10 jeweils bestimmt und untereinander verglichen. Ferner wird ein Ladestrom I3(t), der durch die Batterie 10 während der dritten Phase fließt, in Abhängigkeit von der Zeit t erfasst. Am Ende der dritten Phase ist es möglich, die potentiell gefährlichen Batteriezellen 3, 4 der Batterie 10 von den anderen Batteriezellen 1, 2 der Batterie 10 zu unterscheiden. Der Grund dafür ist, dass am Ende der dritten Phase sowohl die gut funktionierende Batteriezelle 1 der Batterie 10 als auch die mäßig funktionierende Batteriezelle 2 der Batterie 10 unabhängig von einer Höhe ihrer Kapazität Q11, Q12 vollständig geladen sind, während die potentiell gefährlichen Batteriezellen 3, 4 der Batterie 10 nicht vollständig geladen sind. Aus der Figur 1 ist ersichtlich, dass am Ende der dritten Phase die erste Batteriezelle 1 und die zweite Batteriezelle 2 vollständig geladen sind und die dritte Batteriezelle 3 und die vierte Batteriezelle 4 nicht vollständig geladen sind. Folglich ist aus der Figur 1 ersichtlich, dass die dritte Batteriezelle 3 und die vierte Batteriezelle 4 potentiell gefährliche Batteriezellen sind. Folglich ist aus der Figur 1 ferner ersichtlich, dass die erste Batteriezelle 1 und die zweite Batteriezelle 2 jeweils keinen oder einen sehr geringen Selbstentladestrom aufweisen.

Gemäß der ersten Ausführungsform folgt eine vierte Phase unmittelbar nach der dritten Phase. Dabei wird während der vierten Phase wenigstens ein Ladezustandsausgleich zwischen den Ladezuständen L31, L32, L33, L34 der vier Batteriezellen 1, 2, 3, 4 unmittelbar nach einem Beenden der dritten Phase durchgeführt. Anschließend wird die Batterie 10 solange nachgeladen, bis alle vier Batteriezellen 1, 2, 3, 4 vollständig geladen sind. An einem Ende der vierten Phase befindet sich die Batterie 10 in dem vierten Zustand Z4, in dem die vier Batteriezellen 1, 2, 3, 4 vollständig geladen sind.

Gemäß der ersten Ausführungsform wird eine erste Ladungsmenge Q1 bestimmt, die jeder Batteriezelle 1, 2, 3, 4 durch das während der zweiten Phase durchgeführte Entladen entnommen wird. Dabei wird die erste Ladungsmenge Q1 durch eine Integration des während der zweiten Phase vorkommenden Entladestroms I2(t) über einen in der zweiten Phase liegenden ersten Zeitraum tE bestimmt, während dessen der Entladestrom I2(t) durch die Batterie 10 fließt.

Gemäß der ersten Ausführungsform wird ferner eine zweite Ladungsmenge Q2 bestimmt, die jeder Batteriezelle 1, 2, 3, 4 durch das während der dritten Phase durchgeführte Laden zugeführt wird. Dabei wird die zweite Ladungsmenge Q2, durch eine Integration des während der dritten Phase vorkommenden Ladestroms I3(t) über einen in der dritten Phasen liegenden zweiten Zeitraum tL bestimmt, während dessen der Ladestrom I3(t) durch die Batterie 10 fließt.

Gemäß der ersten Ausführungsform wird auch ein jeder Selbstentladestrom Sli einer Batteriezelle i der vier Batteriezellen 1, 2, 3, 4 anhand von während der zweiten und dritten Phase bestimmten Größen bestimmt. Jeder Selbstentladestrom Sli einer Batteriezelle i der vier Batteriezelle 1, 2, 3, 4 wird dabei gemäß der Relation (1) bestimmt.

$$SIi = \frac{-\dfrac{Q1}{1-L2i} + \dfrac{Q2}{L3i} + \dfrac{L2i \cdot Q1}{L3i \cdot (1-L2i)}}{\dfrac{tE+tP1}{1-L2i} + \dfrac{tL+tP2}{L3i} - \dfrac{(tE+tP1) \cdot L2i}{(1-L2i) \cdot L3i}} \tag{1}$$

In der Relation (1) wird ein in der zweiten Phase liegender Zeitraum, während dessen der Entladestrom I2(t) nicht durch die Batterie 10 fließt, mit tP1 bezeichnet. Auch wird in der Relation (1) ein in der dritten Phase liegender Zeitraum, während dessen der Ladestrom I3(t) nicht durch die Batterie 10 fließt, mit tP2 bezeichnet.

Gemäß der ersten Ausführungsform wird ferner jede Kapazität Q1i einer Batteriezelle i der vier Batteriezellen 1, 2, 3, 4 anhand der während der zweiten Phase bestimmten Größen und des für die jeweilige Batteriezelle i bestimmten Selbstentladestroms Sli bestimmt. Die Kapazität Q1i einer Batteriezelle i der vier Batteriezelle 1, 2, 3, 4 wird dabei gemäß der Relation (2) bestimmt.

$$Q1i = \frac{Q1 + SIi \cdot tE + SIi \cdot tP1}{1-L2i} \tag{2}$$

In den Relationen (1) und (2) wird jeder Ladezustand Lji, den eine Batteriezelle i der vier Batteriezellen 1, 2, 3, 4 der sich in einem Zustand Zj der vier Zustände Z1, Z2, Z3, Z4 befindlichen Batterie 10 aufweist, mit zwischen 0 und 1 liegenden Werten bewertet.

Im Folgenden wird für jede Ladungsmenge Qji, die in einer Batteriezelle i der vier Batteriezellen 1, 2, 3, 4 der sich in einem Zustand Zj der vier Zustände Z1, Z2, Z3, Z4 befindlichen und in der Figur 1 gezeigten Batterie 10 gespeichert ist, jeweils ein Beispielwert angegeben. Auch andere Beispielwerte sind denkbar.

Für die sich in dem ersten Zustand Z1 befindlichen Batterie 10 beträgt die in der ersten Batteriezelle 1 gespeicherte Ladungsmenge Q11 15 Ah, die in der zweiten Batteriezelle 2 gespeicherte Ladungsmenge Q12 10 Ah, die in der dritten Batteriezelle 3 gespeicherte Ladungsmenge Q13 15 Ah und die in der vierten Batteriezelle 4 gespeicherte Ladungsmenge Q14 10 Ah.

Für die sich in dem zweiten Zustand Z2 befindlichen Batterie 10 beträgt die in der ersten Batteriezelle 1 gespeicherte Ladungsmenge Q21 7,5 Ah, die in der zweiten Batteriezelle 2 gespeicherte Ladungsmenge Q22 2,5 Ah, die in der dritten Batteriezelle 3 gespeicherte Ladungsmenge Q23 6 Ah und die in der vierten Batteriezelle 4 gespeicherte Ladungsmenge Q24 1 Ah.

Für die sich in dem dritten Zustand Z3 befindlichen Batterie 10 beträgt die in der ersten Batteriezelle 1 gespeicherte Ladungsmenge Q31 15 Ah, die in der zweiten Batteriezelle 2 gespeicherte Ladungsmenge Q32 10 Ah, die in der dritten Batteriezelle 3 gespeicherte Ladungsmenge Q33 13,5 Ah und die in der vierten Batteriezelle 4 gespeicherte Ladungsmenge Q34 8,5 Ah.

Für die sich in dem vierten Zustand Z4 befindlichen Batterie 10 beträgt die in der ersten Batteriezelle 1 gespeicherte Ladungsmenge Q41 15 Ah, die in der zweiten Batteriezelle 2 gespeicherte Ladungsmenge Q42 10 Ah, die in der dritten Batteriezelle 3 gespeicherte Ladungsmenge Q43 15 Ah und die in der vierten Batteriezelle 4 gespeicherte Ladungsmenge Q44 10 Ah.

Neben der voranstehenden schriftlichen Offenbarung wird hiermit zur weiteren Offenbarung der Erfindung ergänzend auf die Darstellung in der Figur 1 Bezug genommen.

## Patentansprüche

1. Verfahren zum Überwachen eines Zustandes wenigstens einer vorbestimmten Batteriezelle (1, 2, 3, 4) einer Batterie (10) mit mehreren in Reihe geschalteten oder in Reihe schaltbaren Batteriezellen (1, 2, 3, 4), **gekennzeichnet durch**:

   Versetzen der Batterie (10) in einen ersten Zustand (Z1), in dem die Batteriezellen (1, 2, 3, 4) jeweils einen vordefinierten Ladezustand aufweisen, während einer ersten Phase,
   Entladen der sich in dem ersten Zustand (Z1) befindlichen Batterie (10) während einer nach der ersten Phase folgenden zweiten Phase, wobei am Ende der zweiten Phase mindestens eine der wenigstens einen vorbestimmten Batteriezelle (1, 2, 3, 4) einen weiteren vordefinierten Ladezustand erreicht,
   Laden der Batterie (10) während einer nach der zweiten Phase folgenden dritten Phase bis zu einem Zeitpunkt, zu dem wenigstens eine Batteriezelle (1, 2) der Batterie (10) den vordefinierten Ladezustand aufweist,
   Erfassen der von der wenigstens einen vorbestimmten Batteriezelle (1, 2, 3, 4) bereitgestellten Spannung zumindest nach einem Beenden des während der zweiten Phase vorkommenden Entladens und zumindest nach einem Beenden des in der dritten Phase vorkommenden Ladens, und Erkennen des Zustands der wenigstens einen vorbestimmten Batteriezelle (1, 2, 3, 4) anhand einer Auswertung der erfassten Spannung,
   wobei die Auswertung der erfassten Spannung eine Auswertung der zumindest nach dem Beenden des während der zweiten Phase vorkommenden Entladens erfassten Spannung und eine Auswertung der zumindest nach dem Beenden des während der dritten Phase vorkommenden Ladens erfassten Spannung umfasst, und
   wobei das Erkennen des Zustands der wenigstens einen vorbestimmten Batteriezelle (1, 2, 3, 4) Erkennen eines der drei folgenden Zustände von Batteriezellen umfasst: 1. ein Zustand einer gut funktionierenden Batteriezelle, die eine hohe Kapazität und keine oder sehr geringe Entladeströme aufweist, 2. ein Zustand einer mäßig funktionierenden Batteriezelle, die eine geringe Kapazität und keine oder sehr geringe Entladeströme aufweist, und 3. ein Zustand einer potentiell gefährlichen Batteriezelle, die hohe Entladeströme aufweist.

2. Verfahren nach Anspruch 1, **gekennzeichnet durch**:
   Erkennen einer jeden zu prüfenden Batteriezelle (3, 4) der wenigstens einen vorbestimmten Batteriezelle (1, 2, 3, 4), die unmittelbar nach dem Beenden des während der dritten Phase durchgeführten Ladens einen gegenüber dem vordefinierten Ladezustand kleineren Ladezustand aufweist, anhand einer Auswertung des nach dem Beenden des während der dritten Phase vorkommenden Ladens erfassten Spannung.

3. Verfahren nach Anspruch 2, **gekennzeichnet durch**:
   Erkennen einer jeden weiteren zu prüfenden Batteriezelle (2) der wenigstens einen vorbestimmten Batteriezelle (1, 2, 3, 4), die unmittelbar nach einem Beenden des während der zweiten Phase durchgeführten Entladens einen Ladezustand aufweist, der einen Ladezustandsschwellenwert unterschreitet, und keine zu prüfende Batteriezelle (3, 4) ist, anhand der Auswertung der zumindest nach dem Beenden des während der zweiten Phase vorkommenden Entladens erfassten Spannung.

4. Verfahren nach einem der vorangehenden Ansprüche, **gekennzeichnet durch**:

   Erfassen des durch die Batterie (10) fließenden Stromes zumindest während des Entladens, das während der zweiten Phase vorkommt, und zumindest während des Ladens, das während der dritten Phase vorkommt, und Bestimmen einer Kapazität und/oder eines Selbstentladestroms der wenigstens einen vorbestimmten Batteriezelle (1, 2, 3, 4) anhand einer Auswertung der erfassten Spannung und des erfassten Stroms.

**5.** Verfahren nach einem der vorangehenden Ansprüche, **gekennzeichnet durch**:
Durchführen wenigstens eines Ladezustandsausgleichs zwischen Ladezuständen der Batteriezellen (1, 2, 3, 4) nach einem Beenden der dritten Phase.

**6.** Verfahren nach Anspruch 5, **gekennzeichnet durch**:

Erfassen von weiteren Informationen über ein Verhalten der wenigstens einen vorbestimmten Batteriezelle (1, 2, 3, 4) der Batterie (10) während des wenigstens einen Ladezustandsausgleichs und
Erkennen jeder zu prüfenden Batteriezelle (3, 4) und/oder jeder weiteren zu prüfende Batteriezelle (2) der wenigstens einen vorbestimmten Batteriezelle (1, 2, 3, 4) anhand einer Auswertung der erfassten weiteren Informationen über die wenigstens eine vorbestimmte Batteriezelle (1, 2, 3, 4) und/oder
Bestimmen der Kapazität und/oder des Selbstentladestroms der wenigstens einen vorbestimmten Batteriezelle (1, 2, 3, 4) anhand der erfassten weiteren Informationen über die wenigstens eine vorbestimmte Batteriezelle (1, 2, 3, 4),
wobei die weiteren Informationen eine jede Energie- oder Ladungsmenge umfassen, die einer vorbestimmten Batteriezelle während des wenigstens einen Ladezustandsausgleichs zugeführt oder entnommen wird.

**7.** Verfahren nach einem der Ansprüche 4 bis 6, **gekennzeichnet durch**:

Erkennen jeder Batteriezelle (1, 2, 3, 4), deren Selbstentladestrom bestimmt wird, jeweils als Batteriezelle (1, 2, 3, 4), die sich in einem kritischen Zustand befindet, wenn der Selbstentladestrom dieser einen Stromschwellenwert überschreitet, und/oder
Erkennen jeder Batteriezelle (1, 2, 3, 4), deren Kapazität bestimmt wird, jeweils als eine Batteriezelle (1, 2, 3, 4), die sich in einem unerwünschten Zustand befindet, wenn die Kapazität dieser jeweils einen Kapazitätsschwellenwert unterschreitet.

**8.** Verfahren nach einem der Ansprüche 4 bis 7, **dadurch gekennzeichnet, dass** jede Batteriezelle (3, 4), deren Selbstentladestrom bestimmt wird, zuerst jeweils als eine zu prüfende Batteriezelle (3, 4) erkannt wurde und/oder jede Batteriezelle (2), deren Kapazität bestimmt wird, zuerst jeweils als eine weitere zu prüfende Batteriezelle (2) erkannt wurde.

**9.** Vorrichtung zum Überwachen eines Zustands wenigstens einer vorbestimmten Batteriezelle (1, 2, 3, 4) einer Batteriezellgruppe, die aus wenigstens einer Batteriezelle (1, 2, 3, 4) einer Batterie (10) besteht, die mehrere in Reihe geschaltete oder in Reihe schaltbare Batteriezellen (1, 2, 3, 4) aufweist, wobei die Vorrichtung dazu ausgebildet ist, ein Vorliegen einer ersten Phase, während der ein Versetzen der Batterie (10) in einen ersten Zustand (Z1) erfolgt, in dem die Batteriezellen (1, 2, 3, 4) der Batterie (10) jeweils einen vordefinierten Ladezustand aufweisen, ein Vorliegen einer nach der ersten Phase folgenden zweiten Phase, während der ein Entladen der sich in dem ersten Zustand (Z1) befindlichen Batterie (10) erfolgt, und ein Vorliegen einer nach der zweiten Phase folgenden dritten Phase, während der ein Laden der Batterie (10) bis zu einem Zeitpunkt erfolgt, zu dem wenigstens eine Batteriezelle (1, 2) der Batterie (10) den vordefinierten Ladezustand aufweist, jeweils zu erkennen und ferner Informationen über den Zustand der wenigstens einen vorbestimmten Batteriezelle (1, 2, 3, 4) der Batteriezellgruppe gemäß einem Verfahren nach einem der Ansprüche 1 bis 8 zu bestimmen.

**10.** Vorrichtung nach Anspruch 9, **dadurch gekennzeichnet, dass** die Vorrichtung bevorzugt dazu ausgebildet ist, ein Durchführen wenigstens eines Ladezustandsausgleichs zwischen Ladezuständen der Batteriezellen (1, 2, 3, 4) zu erkennen, wobei die Vorrichtung ferner dazu ausgebildet ist, für die wenigstens eine vorbestimmte Batteriezelle (1, 2, 3, 4) der Batteriezellgruppe ein Verfahren gemäß einem der Ansprüche 6 bis 8 durchzuführen.

**Claims**

**1.** Method for monitoring a state of at least one predetermined battery cell (1, 2, 3, 4) of a battery (10) comprising a plurality of battery cells (1, 2, 3, 4) connected in series or connectable in series, **characterised by**:

placing the battery (10) in a first state (Z1), in which the battery cells (1, 2, 3, 4) each have a predefined charge state, during a first phase,
discharging the battery (10) which is in the first state (Z1) during a second phase following on from the first phase, at least one of the at least one predetermined battery cell (1, 2, 3, 4) achieving a further predefined charge state at the end of the second phase,
charging the battery (10) during a third phase following on from the second phase, until a time at which the at least one battery cell (1, 2) of the battery (10) has the predefined charge state,
recording the voltage provided by the at least one predetermined battery cell (1, 2, 3, 4), at least after termination of the discharging which occurs during the second phase and at least after termination of the charging which occurs in the third phase, and
detecting the state of the at least one predetermined battery cell (1, 2, 3, 4) by evaluating the recorded voltage, the evaluation of the recorded voltage including evaluating the voltage captured at least after termination of the discharging which occurs during the second phase and evaluating the voltage recorded at least after termination of the charging which occurs during the third phase, and
the detection of the state of the at least one predetermined battery cell (1, 2, 3, 4) including detecting one of the following three states of battery cells: 1. a state of a highly functional battery cell, which has a high capacitance and no or very low discharge currents, 2. a state of a moderately functional battery cell, which has a low capacitance and no or very low discharge currents, and 3. a state of a potentially dangerous battery cell, which has high discharge currents.

2. Method according to claim 1, **characterised by**:
detecting each battery cell (3, 4) to be tested of the at least one predetermined battery cell (1, 2, 3, 4) which has a charge state lower than the predefined charge state immediately after termination of the charging performed during the third phase, by evaluating the voltage recorded after termination of the charging which occurs during the third phase.

3. Method according to claim 2, **characterised by**:
detecting each further battery cell (2) to be tested of the at least one predetermined battery cell (1, 2, 3, 4) which has a charge state falling below a charge state threshold immediately after termination of the discharging performed during the second phase and which is not a battery cell (3, 4) to be tested, by evaluating the voltage detected at least after termination of the discharging which occurs during the second phase.

4. Method according to any of the preceding claims, **characterised by**:

detecting the current flowing through the battery (10) at least during the discharging which occurs during the second phase and at least during the charging which occurs during the third phase, and
determining a capacitance and/or a self-discharge current of the at least one predetermined battery cell (1, 2, 3, 4) by evaluating the recorded voltage and the recorded current.

5. Method according to any of the preceding claims, **characterised by**:
performing at least one charge state comparison between charge states of the battery cells (1, 2, 3, 4) after termination of the third phase.

6. Method according to claim 5, **characterised by**:

recording further information concerning properties of the at least one predetermined battery cell (1, 2, 3, 4) of the battery (10) during the at least one charge state comparison and
detecting each battery cell (3, 4) to be tested and/or
each further battery cell (2) to be tested of the at least one predetermined battery cell (1, 2, 3, 4) by evaluating the recorded further information concerning the at least one predetermined battery cell (1, 2, 3, 4) and/or
determining the capacitance and/or the self-discharge current of the at least one predetermined battery cell (1, 2, 3, 4) using the recorded further information concerning the at least one predetermined battery cell (1, 2, 3, 4), the further information including each energy amount or charge amount supplied to or drawn from a predetermined battery cell during the at least one charge state comparison.

7. Method according to any of claims 4 to 6, **characterised by**:

detecting each battery cell (1, 2, 3, 4) of which the self-discharge current is determined as a battery cell (1, 2, 3, 4) which is in a critical state if the self-discharge current thereof exceeds a current threshold, and/or
detecting each battery cell (1, 2, 3, 4) of which the capacitance is determined as a battery cell (1, 2, 3, 4) which is in an undesirable state if the capacitance thereof falls below a capacitance threshold.

8. Method according to any of claims 4 to 7, **characterised in that** each battery cell (3, 4) of which the self-discharge current is determined has first been detected as a battery cell (3, 4) to be tested, and/or each battery cell (2) of which the capacitance is determined has first been detected as a further battery cell (2) to be tested.

9. Device for monitoring a state of at least one predetermined battery cell (1, 2, 3, 4) of a battery cell group consisting of at least one battery cell (1, 2, 3, 4) of a battery (10) comprising a plurality of battery cells (1, 2, 3, 4) connected in series or connectable in series, the device being configured to detect each of a presence of a first phase, during which the battery (10) is placed in a first state (Z1), in which the battery cells (1, 2, 3, 4) of the battery (10) each have a predefined charge state, a presence of a second phase following on from the first phase, during which the battery (10) which is in the first state (Z1) discharges, and a presence of a third phase following on from the second phase, during which the battery (10) is charged until a time at which at least one battery cell (1, 2) of the battery (10) has the predefined charge state, and to determine further information concerning the state of the at least one predetermined battery cell (1, 2, 3, 4) of the battery cell group by a method according to any of claims 1 to 8.

10. Device according to claim 9, **characterised in that** the device is preferably configured to detect performance of at least one charge state comparison between charge states of the battery cells (1, 2, 3, 4), the device further being configured to perform a method according to any of claims 6 to 8 for the at least one predetermined battery cell (1, 2, 3, 4) of the battery cell group.

**Revendications**

1. Procédé de surveillance d'un état d'au moins une cellule de batterie prédéterminée (1, 2, 3, 4) d'une batterie (10) comprenant plusieurs cellules de batterie (1, 2, 3, 4) connectées en série ou pouvant être connectées en série, **caractérisé par** les étapes consistant à :

   mettre la batterie (10) dans un premier état (Z1) dans lequel les cellules de batterie (1, 2, 3, 4) présentent chacune un état de charge prédéfini, pendant une première phase,
   décharger la batterie (10) se trouvant dans le premier état (Z1) pendant une deuxième phase suivant la première phase, au moins l'une desdites au moins une cellules de batterie prédéterminées (1, 2, 3, 4) atteignant un autre état de charge prédéfini à la fin de la deuxième phase,
   charger la batterie (10) pendant une troisième phase suivant la deuxième phase jusqu'à un instant où au moins une cellule de batterie (1, 2) de la batterie (10) présente l'état de charge prédéfini,
   détecter la tension fournie par ladite au moins une cellule de batterie prédéterminée (1, 2, 3, 4) au moins après une fin de la décharge se produisant pendant la deuxième phase et au moins après une fin de la charge se produisant pendant la troisième phase, et
   identifier l'état de ladite au moins une cellule de batterie prédéterminée (1, 2, 3, 4) à l'aide d'une évaluation de la tension détectée,
   dans lequel l'évaluation de la tension détectée comprend une évaluation de la tension détectée au moins après la fin de la décharge se produisant pendant la deuxième phase et une évaluation de la tension détectée au moins après la fin de la charge se produisant pendant la troisième phase, et
   dans lequel identifier l'état de ladite au moins une cellule de batterie prédéterminée (1, 2, 3, 4) consiste à identifier l'un des trois états suivants de cellules de batterie : 1. un état d'une cellule de batterie fonctionnant bien, qui présente une capacité élevée et pas de courants de décharge ou des courants de décharge très faibles, 2. un état d'une cellule de batterie fonctionnant moyennement, qui présente une faible capacité et pas de courants de décharge ou des courants de décharge très faibles, et 3. un état d'une cellule de batterie potentiellement dangereux, qui présente des courants de décharge élevés.

2. Procédé selon la revendication 1, **caractérisé par** l'étape consistant à :
   identifier chaque cellule de batterie à tester (3, 4) parmi lesdites au moins une cellules de batterie prédéterminées (1, 2, 3, 4) qui présente un état de charge inférieur à l'état de charge prédéfini immédiatement après la fin de la charge effectuée pendant la troisième phase, à l'aide d'une évaluation de la tension détectée après la fin de la charge se produisant pendant la troisième phase.

3. Procédé selon la revendication 2, **caractérisé par** l'étape consistant à :
   identifier chaque autre cellule de batterie à tester (2) parmi lesdites au moins une cellules de batterie prédéterminées (1, 2, 3, 4) qui présente un état de charge qui est inférieur à une valeur seuil d'état de charge immédiatement après une fin de la décharge effectuée pendant la deuxième phase et qui n'est pas une cellule de batterie à tester (3, 4), à l'aide de l'évaluation de la tension détectée au moins après la fin de la décharge se produisant pendant la deuxième phase.

4. Procédé selon l'une des revendications précédentes, **caractérisé par** les étapes consistant à :

détecter le courant circulant dans la batterie (10) au moins pendant la décharge qui se produit pendant la deuxième phase et au moins pendant la charge qui se produit pendant la troisième phase, et
déterminer une capacité et/ou un courant d'autodécharge de ladite au moins une cellule de batterie prédéterminée (1, 2, 3, 4) à l'aide d'une évaluation de la tension et du courant détectés.

5. Procédé selon l'une des revendications précédentes, **caractérisé par** l'étape consistant à :
mettre en œuvre au moins un équilibrage d'états de charge entre les états de charge des cellules de batterie (1, 2, 3, 4) après une fin de la troisième phase.

6. Procédé selon la revendication 5, **caractérisé par** les étapes consistant à :

acquérir d'autres informations sur un comportement de ladite au moins une cellule de batterie prédéterminée (1, 2, 3, 4) de la batterie (10) pendant ledit au moins un équilibrage d'états de charge et
identifier chaque cellule de batterie à tester (3, 4) et/ou chaque autre cellule de batterie à tester (2) parmi lesdites au moins une cellules de batterie prédéterminées (1, 2, 3, 4) à l'aide d'une évaluation des autres informations acquises sur ladite au moins une cellule de batterie prédéterminée (1, 2, 3, 4) et/ou
déterminer la capacité et/ou le courant d'autodécharge de ladite au moins une cellule de batterie prédéterminée (1, 2, 3, 4) à l'aide des autres informations acquises sur ladite au moins une cellule de batterie prédéterminée (1, 2, 3, 4),
lesdites autres informations comprenant une quantité d'énergie ou de charge amenée ou prélevée à une cellule de batterie prédéterminée pendant ledit au moins un équilibrage d'états de charge.

7. Procédé selon l'une des revendications 4 à 6, **caractérisé par** les étapes consistant à :

identifier chaque cellule de batterie (1, 2, 3, 4), dont le courant d'autodécharge est déterminé, comme étant une cellule de batterie (1, 2, 3, 4) qui se trouve dans un état critique lorsque son courant d'autodécharge est supérieur à une valeur seuil de courant, et/ou
identifier chaque cellule de batterie (1, 2, 3, 4), dont la capacité est déterminée, comme étant une cellule de batterie (1, 2, 3, 4) qui se trouve dans un état indésirable lorsque sa capacité est inférieure à une valeur seuil de capacité.

8. Procédé selon l'une des revendications 4 à 7, **caractérisé en ce que** chaque cellule de batterie (3, 4), dont le courant d'autodécharge est déterminé, a d'abord été identifiée comme étant une cellule de batterie à tester (3, 4) et/ou que chaque cellule de batterie (2), dont la capacité est déterminée, a d'abord été identifiée comme étant une autre cellule de batterie à tester (2).

9. Dispositif de surveillance d'un état d'au moins une cellule de batterie prédéterminée (1, 2, 3, 4) d'un groupe de cellules de batterie qui se compose d'au moins une cellule de batterie (1, 2, 3, 4) d'une batterie (10), qui comprend plusieurs cellules de batterie (1, 2, 3, 4) connectées en série ou pouvant être connectées en série, le dispositif étant conçu pour identifier respectivement l'existence d'une première phase, pendant laquelle la batterie (10) est mise dans un premier état (Z1) dans lequel les cellules de batterie (1, 2, 3, 4) de la batterie (10) présentent chacune un état de charge prédéfini, l'existence d'une deuxième phase suivant la première phase, pendant laquelle a lieu une décharge de la batterie (10) se trouvant dans le premier état (Z1), et l'existence d'une troisième phase suivant la deuxième phase, pendant laquelle a lieu une charge de la batterie (10) jusqu'à un instant où au moins une cellule de batterie (1, 2) de la batterie (10) présente l'état de charge prédéfini, et en outre pour déterminer des informations sur l'état de ladite au moins une cellule de batterie prédéterminée (1, 2, 3, 4) du groupe de cellules de batterie conformément à un procédé selon l'une des revendications 1 à 8.

10. Dispositif selon la revendication 9, **caractérisé en ce que** le dispositif est de préférence conçu pour identifier une mise en œuvre d'au moins un équilibrage d'états de charge entre les états de charge des cellules de batterie (1, 2, 3, 4), le dispositif étant en outre conçu pour mettre en oeuvre, pour ladite au moins une cellule de batterie prédéterminée (1, 2, 3, 4) du groupe de cellules de batterie, un procédé selon l'une des revendications 6 à 8.

# FIG. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 102231546 B
- US 20140077764 A1

- US 20130018606 A